Europäisches Patentamt

**European Patent Office**

**Office européen des brevets**

(19)

(11) Publication number: **0 037 621**
A2

# EUROPEAN PATENT APPLICATION

(12)

(21) Application number: **81300438.9**

(22) Date of filing: **03.02.81**

(51) Int. Cl.³: **H 01 R 23/72**

(30) Priority: **22.02.80 US 123592**

(43) Date of publication of application:
**14.10.81 Bulletin 81/41**

(84) Designated Contracting States:
**AT BE CH DE FR GB IT LI NL SE**

(71) Applicant: **AMP INCORPORATED**
**Eisenhower Boulevard**
**Harrisburg, Pennsylvania(US)**

(72) Inventor: **Olsson, Billy Erik**
**709 Drexel Hills Boulevard**
**New Cumberland Pennsylvania 17070(US)**

(74) Representative: **Wayte, Dennis Travers et al,**
**20 Queensmere**
**Slough, Berkshire SL1 1YZ(GB).**

(54) **Electrical connector for use in establishing connections to a rectangular planar substrate.**

(57) An electrical connector for use in establishing connections to a rectangular planar substrate (100) comprises a housing (1) with three upstanding walls (3, 4, 5) carrying terminals (7) and between which the substrate (100) is received with the substrate (100) projecting beyond the fourth side of the housing (1). Movement of the substrate (100) in its plane out of the housing (1) is prevented by ribs (17) on opposed walls (3, 4) of the housing (1) engaging in slots (106) in the substrate (100) the ribs (17) and slots (106) being located such as to ensure equal loading of all of the terminals (7) carried by the housing (1).

FIG.1

Electrical connector for use in establishing connections to a rectangular planar substrate.

This invention relates to an electrical connector for use in establishing connections to a rectangular planar substrate.

In British Patent Specification No. 1,442,339 there is disclosed such a connector comprising an insulating housing having a base and upstanding side walls within which the substrate is to be received, the side walls being formed with pockets each of which receives a conductive terminal having a resilient contact arm adapted and arranged to engage a contact pad on an edge of the substrate when received within the housing walls.

This known connector has four side walls within which the substrate is received, and thus the substrate is always accurately aligned in two mutually perpendicular directions, parallel to the edges of the substrate, within the housing. Further, in this known connector all connections to the substrate are made by means of the terminals carried by the housing, there being only two opposed rows of terminals.

There is now a need for such a connector in which connections can be made directly to the substrate other than by way of the terminals carried by the housing, for example by way of a conventional printed circuit board edge connector mated with one edge of the substrate.

Such direct connection can be achieved by giving the housing only three side walls whereby the substrate can project beyond the open edge of the housing base to be accessible to an edge connector. However, when the housing has only three side walls provision must be made to retain the substrate in the housing against movement away from the side wall opposed to the open edge of the housing base.

When only three side walls are provided it is desirable for each of these side walls to carry terminals, in order to provide the maximum possible number of connections to the substrate in a connector of given size. It is also desirable for all the terminals used to be identical in order to achieve relatively cheap and easy manufacture of the connector.

According to this invention there is provided an electrical connector for use in establishing connections to a rectangular planar substrate, comprising an insulating housing having a base and upstanding side walls within which the substrate is to be received, the side walls being formed with pockets each of which receives a conductive terminal having a resilient contact arm adapted and arranged to engage a contact pad on an edge of the substrate when received within the housing walls, characterised in that there are only three side walls whereby the substrate can project beyond the open edge of the housing base, the opposed side walls extending at right-angles to the open edge each being formed with an inwardly directed rib adapted and arranged to engage in a slot in an edge of the substrate when received within the housing walls thereby to locate the substrate within the housing walls, each rib being located at a distance equal to one half of the nominal dimension of the substrate between the edges thereof received between said opposed side walls, from the side wall opposed to the open edge of the housing base.

The connector of this invention has the advantages that by the provision of only three side walls the substrate can project beyond the open edge of the housing base, while the means provided to secure the substrate in the housing against movement away from the side wall opposed to the open edge of the housing base ensures substantially equal loading of all the terminals of the connector.

This invention will now be described by way of example with reference to the drawings, in which:-

Figure 1 is a perspective view of a connector according to this invention with a terminal exploded therefrom, and also showing a substrate for mounting in the connector;

Figure 2 is a plan view of part of the connector of Figure 1 with the substrate mounted therein;

Figure 3 is a perspective view of a terminal as used in the connector of Figure 1;

Figure 4 is a sectional side elevational view of part of the connector of Figure 1 showing one terminal in its pocket in the housing, taken on the line IV - IV in Figure 5; and

Figure 5 is a sectional view on the line V - V in Figure 4, and showing the terminal under various loading conditions.

The connector shown in the drawings is for use in establishing connections to a rectangular planar substrate 100 comprising a ceramic support 101 carrying a plurality of integrated circuit devices 102 which are connected by conductors on the support 101 to contact pads 103 arranged along three edges of the support 101 and to contact strips 104 at the fourth edge of the support 101, which fourth edge is adapted for mating with a conventional printed circuit board edge connector or connectors (not shown).

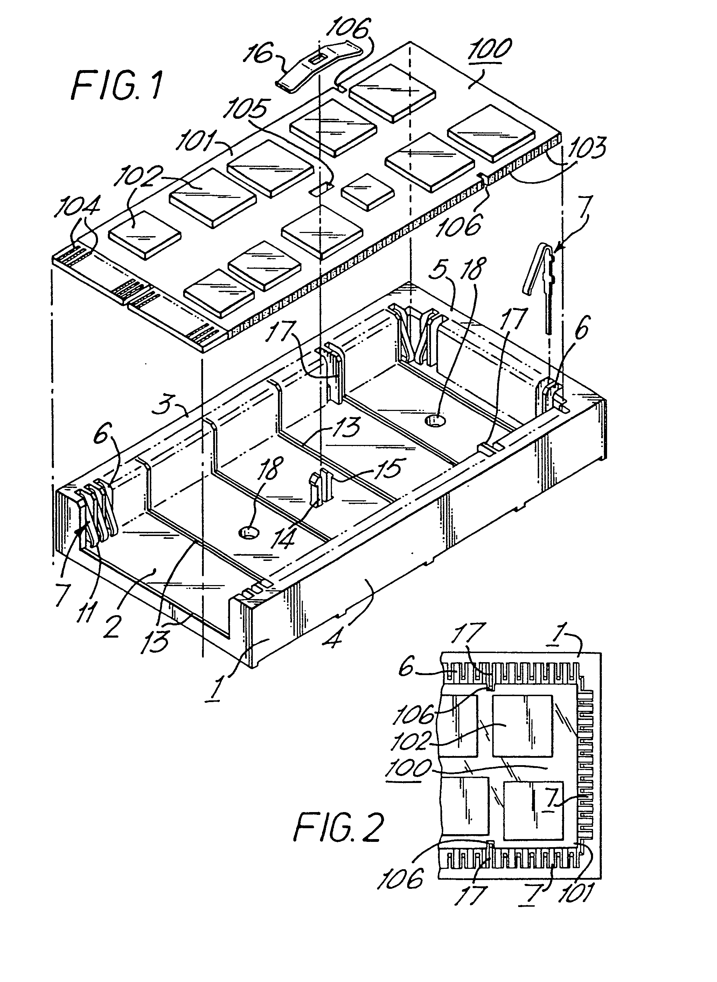

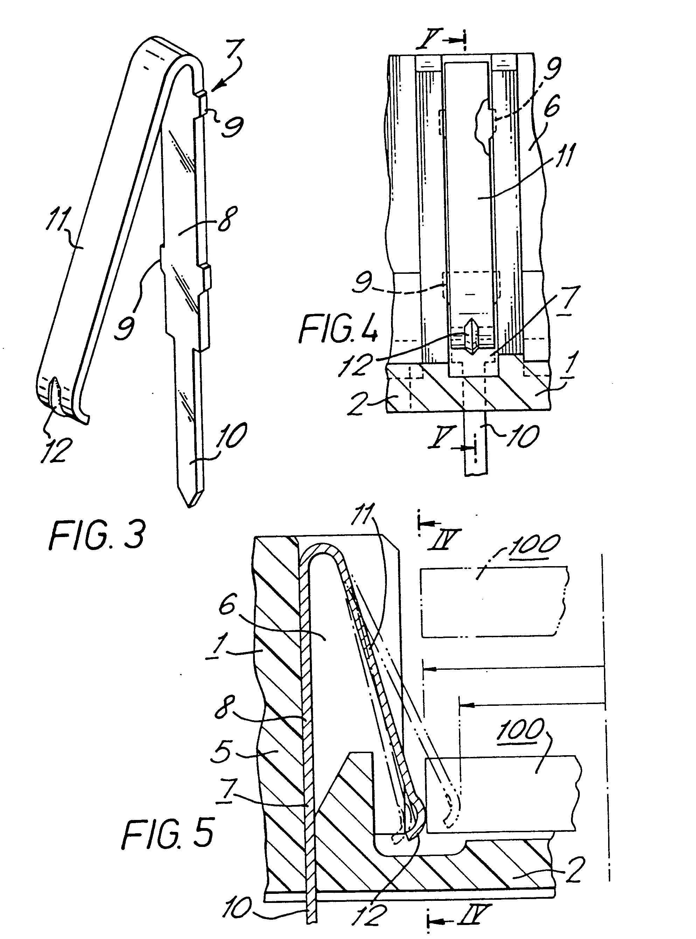

The connector comprises an insulating housing 1 moulded from plastics material and having a substantially planar base 2 and three upstanding side walls 3, 4 and 5. Each of the side walls 3, 4, 5 is formed with a plurality of pockets 6 each of which receives a conductive terminal 7, as shown in Figure 3. Each terminal 7 is stamped and formed from non-magnetic sheet metal and comprises a mounting portion 8 formed on each side with two laterally extending ears 9 by which the terminal 7 is wedged in the associated pocket 6 in the housing 1; a post portion 10 which projects through the base 2 of the housing 1 for receipt in a hole in, for example, a printed circuit board on which the connector is to be mounted; and a reversely bent resilient contact arm 11 having a contact pimple 12 at its free end, which free end, in the rest condition of the contact arm 11, projects out of the associated pocket 6 over the base 2 of the housing 1, as shown in Figure 1.

When the substrate 100 is lowered into the connector from the position shown in Figure 1 to that shown in Figures 2 and 5, it comes to rest on a plurality of upstanding ribs 13 on the base 2 of the housing 1, with the contact pimples 12 of the terminals 7 in contact with the pads 103 on the edges of the support 101, and with the fourth edge of the support 101 carrying the contact strips 104 projecting beyond the open edge (nearest edge in Figure 1) of the housing base 2.

The substrate 100 is secured to the connector against movement in the direction away from the housing base 2, by a split post 14 upstanding from the base 2 of the housing 1 and adapted and arranged to be received freely in a hole 105 in the substrate 100 when received within the housing walls 3, 4, 5, the free ends of the two parts of the post 14 being formed with shoulders 15 under which a spring clip 16 is received, the clip 16 engaging the substrate 100 and urging it towards the base 2 of the housing 1.

As clearly shown in Figure 1, the opposed side walls 3 and 4 extending at right angles to the open edge of the base 2 are each formed with an inwardly directed rib 17 adapted and arranged to engage in a slot 106 in an edge of the substrate 100 when received within the housing walls

3, 4, 5 thereby to locate the substrate 100 within the housing walls 3, 4, 5. Each rib 17 is located at a distance equal to one half of the nominal dimension of the substrate 100 between the edges thereof received between the opposed side walls 3 and 4, from the side wall 5 opposed to the open edge of the housing base 2.

This positioning of the ribs 17 ensures that the loading, that is the flexing of their contact arms 11, of terminals 7 carried by the wall 5 is substantially equal to that of the terminals 7 carried by the walls 3, 4, this being desirable since all of the terminals 7 are identical. When the substrate 100 is inserted into the connector any dimensional tolerance variation of the substrate 100 from its nominal dimension between the edges received between the housing walls 3 and 4 is equally shared between the terminals 7 carried by the wall 3 and those carried by the wall 4, and the substrate 100 thus imposes an equal loading on the terminals carried by the walls 3 and 4, this loading being dependent upon the value of half the actual dimension between the edges of the substrate 100 received between the walls 3 and 4. Similarly, due to the specified positioning of the ribs 17 the loading on the terminals 7 carried by the wall 5 is dependent upon the same actual dimension, and thus this loading is the same as that for the terminals carried by the walls 3 and 4.

Figure 5 illustrates in dotted line the flexing of the contact arm 11 of a terminal 7 by substrates 100 within a range of dimensional tolerances.

The substrate 100 can be removed from the connector by removing the clip 16 from the post 14 and then urging the substrate 100 away from the housing base 2 by means of a tool, such as a screwdriver, inserted through holes 18 in the housing base 2.

Claims:-

1. An electrical connector for use in establishing connections to a rectangular planar substrate (100), comprising an insulating housing (1) having a base (2) and upstanding side walls (3, 4, 5) within which the substrate (100) is to be received, the side walls (3, 4, 5) being formed with pockets (6) each of which receives a conductive terminal (7) having a resilient contact arm (11) adapted and arranged to engage a contact pad (103) on an edge of the substrate (100) when received within the housing walls (3, 4, 5), characterised in that there are only three side walls (3, 4, 5) whereby the substrate (100) can project beyond the open edge of the housing base (2), the opposed side walls (3, 4) extending at right-angles to the open edge each being formed with an inwardly directed rib (17) adapted and arranged to engage in a slot (106) in an edge of the substrate (100) when received within the housing walls (3, 4, 5) thereby to locate the substrate (100) within the housing walls (3, 4, 5), each rib (17) being located at a distance equal to one half of the nominal dimension of the substrate (100) between the edges thereof received between said opposed side walls (3, 4), from the side wall (5) opposed to the open edge of the housing base (2).

2. A connector as claimed in Claim 1, characterised in that all of the terminals (7) are identical.

3. A connector as claimed in Claim 1 or Claim 2, characterised in that each terminal has a post portion (10) projecting away from the outer surface of the base (2) of the housing (1), for receipt in an aperture in a support on which the substrate (100) is to be mounted.

4. A connector as claimed in any preceding claim, characterised by a post (14) upstanding from the base (2) of the housing (1) between the side walls (3, 4, 5) and adapted and arranged to be received freely in a hole (105) in the substrate (100) when received within the housing walls (3, 4, 5), and a clip (16) engageable with the free end of the post (14) and over the substrate (100) when received within the housing walls (3, 4, 5) thereby to prevent movement of the substrate (100) away from the base (2) of the housing (1).

FIG.1

FIG.2

FIG. 3

FIG. 4

FIG. 5